(19) Europäisches Patentamt
European Patent Office
Office européen des brevets

(11) **EP 3 729 553 B1**

(12) **FASCICULE DE BREVET EUROPEEN**

(45) Date de publication et mention
de la délivrance du brevet:
**05.10.2022 Bulletin 2022/40**

(21) Numéro de dépôt: **18816146.7**

(22) Date de dépôt: **18.12.2018**

(51) Classification Internationale des Brevets (IPC):
***H01M 10/44*** *(2006.01)*

(52) Classification Coopérative des Brevets (CPC):
**H01M 10/44; Y02E 60/10**

(86) Numéro de dépôt international:
**PCT/EP2018/085614**

(87) Numéro de publication internationale:
**WO 2019/121756 (27.06.2019 Gazette 2019/26)**

(54) **PROCÉDÉ DE GESTION D'UN ÉTAT DE CHARGE D'UNE BATTERIE LAISSÉE AU REPOS**

VERFAHREN ZUR VERWALTUNG DES LADUNGSZUSTANDES EINER BATTERIE, DIE RUHT

METHOD OF MANAGEMENT OF THE STATE OF CHARGE OF A BATTERY LEFT AT REST

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **20.12.2017 FR 1762616**

(43) Date de publication de la demande:
**28.10.2020 Bulletin 2020/44**

(73) Titulaire: **Commissariat à l'Energie Atomique et
aux Energies
Alternatives
75015 Paris (FR)**

(72) Inventeur: **DELAILLE, Arnaud
73000 BASSENS (FR)**

(74) Mandataire: **Cabinet Camus Lebkiri
25 rue de Maubeuge
75009 Paris (FR)**

(56) Documents cités:
**US-A1- 2004 066 171     US-A1- 2016 266 979
US-B1- 6 664 764**

## Description

### DOMAINE TECHNIQUE DE L'INVENTION

La présente invention concerne un procédé de gestion d'un état de charge d'une batterie laissée au repos.

### ARRIÈRE-PLAN TECHNOLOGIQUE DE L'INVENTION

Une alimentation sans interruption, également appelée UPS pour « Uninterruptible Power Supply » en anglais, est un dispositif qui a pour fonction d'alimenter une charge en énergie électrique lorsque l'alimentation principale de cette charge est défaillante. Un tel dispositif procure une protection contre les coupures de courant en fournissant de l'énergie électrique stockée par exemple dans une batterie rechargeable.

Dans ce type d'application, la batterie a un fonctionnement dit « non cyclé », c'est-à-dire qu'elle n'est ni chargée ni déchargée pendant des périodes prolongées. La batterie est laissée au repos. Cependant, en cas de coupure d'alimentation, la batterie est censée prendre le relai pendant un certain temps.

La batterie est généralement maintenue à pleine charge. Or il est connu que cette façon de procéder a pour conséquence de provoquer un vieillissement prématuré et donc une perte de capacité de la batterie. Il est donc souvent nécessaire de devoir remplacer la batterie pour que le dispositif soit toujours en mesure d'assurer son rôle.

Par ailleurs, le document US2004/0066171 A1 décrit un procédé pour ajuster l'état de charge d'une batterie équipant un appareil mobile tel qu'un téléphone portable, un ordinateur portable ou un appareil photo numérique, en fonction de l'emploi du temps de l'utilisateur de l'appareil. En particulier, la batterie est complètement chargée lorsqu'il est prévu un besoin élevé d'autonomie. Inversement, la batterie est placée dans un état de charge plus faible lorsqu'il est prévu de connecter l'appareil à une source d'alimentation externe.

Les documents US2016/266979 A1 et US6664764 B1 décrivent d'autres procédés de gestion de batterie selon l'art antérieur.

### RÉSUMÉ DE L'INVENTION

Il ressort de ce qui précède qu'il existe un besoin de disposer d'une méthode permettant d'optimiser la charge d'une batterie pour qu'elle puisse remplir la fonction qui lui est assignée tout en limitant son vieillissement.

La présente invention vise à répondre à ce besoin en proposant un procédé de gestion d'un état de charge d'une batterie laissée au repos et subissant des pertes de capacité au cours du temps, le procédé de gestion comportant les étapes suivantes répétées à intervalles de temps réguliers :

- déterminer les pertes de capacité subies par la batterie pendant un intervalle de temps ;
- déterminer une valeur cible de l'état de charge, la valeur cible de l'état de charge étant égale à une quantité de charge cible divisée par une capacité de décharge maximale de la batterie, la quantité de charge cible étant supérieure ou égale à la somme entre les pertes de capacité subies par la batterie et une quantité de charge minimale nécessaire au fonctionnement pendant une durée prédéterminée d'un dispositif électrique associé à la batterie, la valeur cible de l'état de charge étant strictement inférieure à 100 % ;
- ajuster l'état de charge de la batterie à la valeur cible.

Grâce au procédé de l'invention, la batterie présente un niveau de charge qui permet à la batterie à la fois d'exécuter une certaine fonction pendant une durée prédéterminée et de prolonger sa durée de vie en n'étant pas maintenue à pleine charge.

Le procédé de gestion selon l'invention peut également comporter une ou plusieurs caractéristiques parmi les suivantes considérées individuellement ou selon toutes les combinaisons techniquement possibles.

Selon un mode de mise en œuvre, les pertes de capacité subies par la batterie sont déterminées à partir d'une précédente valeur cible de l'état de charge et d'une quantité de charge résiduelle présente dans la batterie.

Selon un mode de mise en œuvre, l'étape de détermination des pertes de capacité subies par la batterie comprend les sous-étapes suivantes

- déterminer des pertes de capacité irréversibles à partir d'une valeur courante de la capacité de décharge maximale et d'une valeur précédente de la capacité de décharge maximale ; et
- déterminer des pertes de capacité réversibles à partir de la précédente valeur cible de l'état de charge, de la quantité de charge résiduelle présente dans la batterie et des pertes de capacité irréversibles.

Selon un mode de mise en œuvre, la quantité de charge résiduelle présente dans la batterie est mesurée lors d'une première opération d'un test de capacité et en ce que la capacité de décharge maximale de la batterie est mesurée lors d'une deuxième opération du test de capacité.

Selon un mode de mise en œuvre, le test de capacité comprend successivement une première phase de décharge complète de la batterie, une phase de charge complète de la batterie et une deuxième phase de décharge complète de la batterie, la quantité de charge résiduelle présente dans la batterie étant mesurée lors de la première phase de décharge complète de la batterie et la capacité de décharge maximale de la batterie étant mesurée lors de la deuxième phase de décharge complète de la batterie.

Selon une variante de mise en œuvre, la batterie présente un rendement faradique atteignant sensiblement 100% et en ce que le test de capacité comprend successivement une phase de décharge complète de la batterie et une phase de charge complète de la batterie, la quantité de charge résiduelle présente dans la batterie étant mesurée lors de la phase de décharge complète de la batterie et la capacité de décharge maximale de la batterie étant mesurée lors de la phase de charge complète de la batterie.

Selon un mode de mise en œuvre, le procédé de gestion comporte en outre une étape consistant à vérifier si la batterie présente une capacité de décharge maximale supérieure ou égale à la quantité de charge cible correspondant à la valeur cible de l'état de charge.

Selon un mode de mise en œuvre, les pertes de capacité comprennent des pertes réversibles dont une première partie est due à un courant de consommation délivré par la batterie, la première partie des pertes réversibles étant compensée entre deux étapes d'ajustement de l'état de charge successives.

Selon un mode de mise en œuvre, la compensation de la première partie des pertes réversibles est prise en compte au cours de l'étape de détermination des pertes de capacité.

Selon un mode de mise en œuvre, le procédé de gestion comporte en outre une étape de mesure d'une température de fonctionnement de la batterie, une capacité de décharge instantanée de la batterie étant déterminée en fonction de la température de fonctionnement de la batterie.

Selon un mode de mise en œuvre, la valeur cible de l'état de charge est modifiée en fonction de la capacité de décharge instantanée.

## BRÈVE DESCRIPTION DES FIGURES

L'invention et ses différentes applications seront mieux comprises à la lecture de la description qui suit et à l'examen des figures qui l'accompagnent, parmi lesquelles :

- la figure 1 est une représentation fonctionnelle d'un procédé de gestion d'un état de charge d'une batterie, selon un mode de mise en œuvre de l'invention ;
- la figure 2 représente schématiquement l'état de la batterie au cours de différentes étapes du procédé de la figure 1.

Les figures ne sont présentées qu'à titre indicatif et nullement limitatif de l'invention.

Pour plus de clarté, les éléments identiques ou similaires sont repérés par des signes de référence identiques sur toutes les figures.

## DESCRIPTION DÉTAILLÉE DE MODES DE MISE EN ŒUVRE DE L'INVENTION

Une batterie est un dispositif de stockage d'énergie électrique qui peut être notamment caractérisée par deux paramètres, à savoir un état de santé, également appelé SOH pour « State Of Health » en anglais, et un état de charge, également appelé SOC pour « State Of Charge » en anglais.

L'état de santé est exprimé en pourcentage et correspond au rapport entre la capacité de décharge maximale $Q_{max}$ et la capacité nominale Qo de la batterie. La capacité de décharge maximale $Q_{max}$ représente la quantité de charge que la batterie peut fournir lorsqu'elle est complètement chargée. La capacité nominale Qo est la capacité de décharge maximale initiale de la batterie, c'est-à-dire lorsque la batterie est neuve. Plus la capacité de décharge maximale est proche de la capacité nominale, meilleur est l'état de santé de la batterie.

L'état de charge est exprimé en pourcentage et correspond au rapport entre la quantité de charge Q(t) stockée dans la batterie à un instant t donné et la capacité de décharge maximale $Q_{max}$ de la batterie (à cet instant).

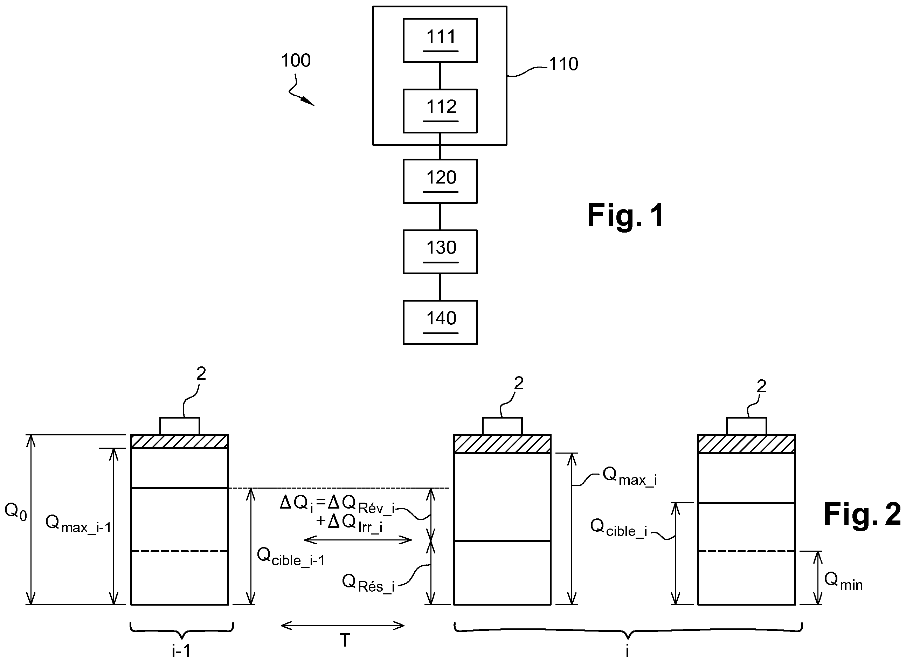

Un mode de mise en œuvre d'un procédé de gestion 100 de l'état de charge d'une batterie 2 selon l'invention va maintenant être décrit en référence aux figures 1 et 2.

Dans le contexte de l'invention, la batterie 2 est laissée au repos pendant une durée prolongée, en particulier dans un état de charge non nul. Autrement dit, pendant cette durée, la batterie 2 n'est pas utilisée pour fournir de l'énergie électrique. Toutefois, la batterie 2 est destinée à délivrer une quantité d'énergie électrique prédéterminée pour permettre à un dispositif électrique d'exécuter une fonction pendant un certain temps. Par exemple, le dispositif électrique équipé de la batterie peut être une alimentation sans interruption, également appelée UPS pour « Uninterruptible Power Supplies » en anglais, consistant à délivrer du courant en cas de défaillance du système d'alimentation principal. Un autre exemple est celui d'une batterie d'un bloc autonome d'éclairage de sécurité (BAES), consistant à alimenter un système d'éclairage en cas de coupure d'électricité pour indiquer une sortie de secours. On peut également citer à titre d'exemple, toujours non limitatif, le cas d'une batterie d'un vélo à assistance électrique ou encore d'un outillage électroportatif, non utilisée parfois sur des périodes prolongées, mais pouvant être conservée avantageusement à un état de charge non nul pour dépanner en cas de besoin immédiat.

On entend par « durée prolongée » une durée au cours de laquelle la batterie 2 subie des pertes de capacité qui peuvent être quantifiées, les pertes de capacité étant par exemple supérieures à 1% de l'état de charge de la batterie 2. Il est à noter que les pertes de capacité dépendent des conditions de stockage de la batterie 2, et en particulier de la température, de l'état de charge et de l'état de santé de la batterie 2.

En fonction du type d'application, la batterie 2 peut être une batterie lithium-ion (Li-ion), une batterie nickel-hydrure métallique (NiMH), une batterie au plomb, une batterie sodium-ion, une batterie sodium-chlorure de nickel, ou tout autre batterie adaptée.

Le procédé de gestion 100 comporte une première étape 110 de détermination des pertes de capacité $\Delta Q_i$ subies par la batterie 2, une deuxième étape 120 de détermination d'une valeur cible $SOC_{cible\_i}$ de l'état de charge de la batterie 2, en fonction notamment des pertes de capacité $\Delta Q_i$ subies par la batterie 2, et une troisième étape 130 d'ajustement de l'état de charge de la batterie 2 à la valeur cible $SOC_{cible\_i}$. La valeur cible $SOC_{cible\_i}$ de l'état de charge est strictement inférieure à 100 %.

Les étapes 110, 120 et 130 du procédé de gestion 100 sont répétées à intervalles réguliers, autrement dit périodiquement. Ainsi, grâce à l'invention, la charge de la batterie 2 est régulièrement mise à un niveau suffisant pour permettre d'exécuter la fonction du dispositif électrique pendant une durée prédéterminée, ce niveau étant toutefois inférieur au niveau de pleine charge (SOC = 100 %). La batterie 2 n'est donc pas maintenue en permanence à sa pleine charge, ce qui augmente sa durée de vie.

Pour donner un ordre d'idées de la période T de répétition des étapes 110, 120 et 130 du procédé de gestion 100, c'est-à-dire la période de temps entre deux itérations successives des étapes 110, 120 et 130, on citera l'exemple des blocs autonomes d'éclairage de sécurité (BAES) pour lesquels l'état des batteries est vérifié environ tous les trois mois. Il est bien entendu que cette valeur de T = 3 mois est donnée à titre indicatif et que la période T avec laquelle les étapes 110, 120 et 130 sont répétées peut prendre n'importe quelle valeur adaptée au contexte de mise en œuvre de l'invention.

Les pertes de capacité peuvent être classées en deux catégories, à savoir les pertes irréversibles et les pertes réversibles.

Les pertes de capacité irréversibles correspondent à une diminution de la capacité de décharge maximale de la batterie 2. En d'autres termes, il s'agit de pertes définitives d'autonomie qui ne peuvent pas être recouvrées en rechargeant la batterie 2. Les pertes irréversibles sont dues au vieillissement de la batterie 2 et elles peuvent être suivies à travers le paramètre d'état de santé de la batterie 2.

Inversement, les pertes de capacité réversibles correspondent à une diminution de la quantité de charge stockée dans la batterie 2. Les pertes réversibles peuvent donc être recouvrées en rechargeant la batterie 2. Les pertes réversibles peuvent être suivies à travers le paramètre d'état de charge de la batterie 2. Les pertes réversibles comportent une première part appelée « autodécharge » et une deuxième part correspondant à une consommation tirée de la batterie 2.

L'autodécharge est due à des réactions électrochimiques parasites qui entraînent une diminution de l'état de charge de la batterie 2, même lorsque cette dernière n'est pas sollicitée. L'autodécharge peut également être provoquée par un transfert d'électrons d'une électrode à l'autre dû à des défauts de fabrication et/ou à la conductivité électronique de l'électrolyte.

La valeur de l'autodécharge dépend de l'état de charge et de la température de la batterie 2. À titre d'exemple, l'état de charge d'une batterie lithium-ion à une température de 30°C diminue d'environ 4%, respectivement 8%, par mois lorsque l'état de charge initial est de l'ordre de 30% à 40%, respectivement 100%. Lorsque la température de la batterie lithium-ion est de 45°C, la diminution de l'état de charge passe à environ 8%, respectivement 25%, pour un état de charge initial de l'ordre de 30% à 40%, respectivement 100%

La consommation tirée de la batterie 2 peut être due à un courant de fuite, à un courant alimentant un dispositif de gestion électronique de la batterie 2, également appelé BMS pour « Battery Management System » en anglais, et/ou à un courant utilisé dans le cadre d'une gestion thermique de la batterie 2. La gestion thermique consiste à refroidir ou à réchauffer la batterie dans le but de limiter son vieillissement.

Les pertes de capacité (totales) $\Delta Q_i$ sont égales à la somme des pertes de capacité réversibles $\Delta Q_{Rév\_i}$ et des pertes de capacité irréversibles $\Delta Q_{Irr\_i}$ subies par la batterie 2 au cours de la dernière période de temps T écoulée, autrement dit depuis la dernière itération des étapes 110 à 130 ou depuis l'origine (i.e. la première mise en service de la batterie) lorsqu'il s'agit de la première itération des étapes 110 à 130 :

$$\Delta Q_i = \Delta Q_{Irr\_i} + \Delta Q_{Rév\_i}$$

où i est un entier strictement positif désignant l'itération en cours.

Les pertes de capacité (totales) $\Delta Q_i$ peuvent être calculées à l'aide de l'équation suivante :

$$\Delta Q_i = Q_{cible_{i-1}} - Q_{Rés\_i}$$

où $Q_{Rés\_i}$ est la quantité de charge résiduelle stockée dans la batterie 2 au début de l'étape 110 d'indice i et $Q_{cible\_i-1}$ est la quantité de charge cible correspondant à la valeur cible $SOC_{cible\_i-1}$ d'état de charge définie lors la dernière mise à niveau de l'état de charge, c'est-à-dire lors de l'itération précédente i-1 des étapes 110 à 130. Pour la première itération des étapes 110 à 130 (i = 1), la quantité de charge cible $Q_{cible\_0}$ est par exemple choisie égale à 110 % de la quantité de charge minimale nécessaire au fonctionnement du dispositif électrique pendant une durée prédéterminée et appelée ci-après Qmin ($Q_{cible\_0}$ = 1,1*Qmin).

Dans un mode de mise en œuvre préférentiel du procédé de gestion 100, on cherche à distinguer les pertes de capacités réversibles des pertes de capacité irréversibles de la batterie 2. La première étape 110 du procédé de gestion 100 comprend alors une première sous-étape 111 de détermination des pertes de capacité irréversibles $\Delta Q_{Irr\_i}$ subies par la batterie 2 au cours de la dernière période de temps T écoulée.

Les pertes de capacité irréversibles $\Delta Q_{Irr\_i}$ subies par la batterie 2 entre l'étape 110 d'indice i-1 et l'étape 110 d'indice i peuvent être calculées à l'aide de l'équation suivante :

$$\Delta Q_{Irr\_i} = Q_{max\_i-1} - Q_{max\_i}$$

où $Q_{max\_i-1}$ est la capacité de décharge maximale de la batterie 2 lors de l'étape 110 d'indice i-1 et $Q_{max\_i}$ est la capacité de décharge maximale de la batterie 2 lors de l'étape 110 d'indice i. Lors de la première itération des étapes 110 à 130 (i = 1), la capacité de décharge maximale $Q_{max\_0}$ de la batterie 2 est égale est à la capacité nominale $Q_0$ de la batterie.

Dans ce même mode de mise en œuvre préférentiel, la première étape 110 du procédé de gestion 100 comprend une deuxième sous-étape 112 de détermination des pertes de capacité réversibles $\Delta Q_{Rév\_i}$ subies par la batterie 2 au cours de la dernière période de temps T écoulée.

Les pertes de capacité réversibles $\Delta Q_{Rév\_i}$ subies par la batterie 2 entre l'étape 110 d'indice i-1 et l'étape 110 d'indice i peuvent être calculées à l'aide de l'équation suivante :

$$\Delta Q_{Rév\_i} = Q_{cible_{i-1}} - Q_{Rés\_i} - \Delta Q_{Irr\_i}$$

La quantité de charge résiduelle $Q_{Rés\_i}$ est de préférence mesurée au cours d'une première opération d'un test de capacité. Ce test de capacité comprend par exemple une première phase de décharge complète, suivie d'une phase de charge complète et d'une deuxième phase de décharge complète. La quantité de charge résiduelle $Q_{Rés\_i}$ est par exemple mesurée en intégrant le courant fourni par la batterie 2 pendant la première phase de décharge complète du test de capacité.

La capacité de décharge maximale $O_{max\_i}$ est de préférence mesurée au cours d'une deuxième opération du test de capacité, par exemple en intégrant le courant fourni par la batterie 2 au cours de la deuxième phase de décharge complète.

Selon un autre mode de mise en œuvre, lorsque la batterie 2 présente un rendement faradique sensiblement égal à 100%, la capacité de décharge maximale $Q_{max\_i}$ de la batterie 2 peut être mesurée directement pendant la phase de charge complète qui suit la première phase de décharge complète permettant de mesurer la quantité de charge résiduelle $Q_{Rés\text{-}i}$. Ainsi, la mesure de la capacité de décharge maximale $O_{max\_i}$ est réalisée plus rapidement, ce qui réduit le temps pendant lequel la batterie 2 n'assure plus sa fonction.

Dans l'ensemble de la description et dans les revendications, on entend par «rendement faradique sensiblement égal à 100% » un rendement faradique supérieure ou égal à 99 %. Dans ce cas, la quantité de charge chargée dans la batterie 2 est considérée équivalente à la quantité de charge délivrée. C'est le cas par exemple pour les batteries lithium-ion.

La valeur cible $SOC_{cible\_i}$ est définie de manière à ce que la batterie 2 comporte à la fin d'une période de temps T (i.e. juste avant une nouvelle mise à niveau de l'état de charge) une quantité de charge supérieure ou égale à une quantité de charge minimale $Q_{min}$ nécessaire pour exécuter pendant la durée souhaitée la fonction du dispositif électrique associé à la batterie 2. La valeur cible $SOC_{cible\_i}$ de l'état de charge est déterminée lors de l'étape 120 à partir de la capacité de décharge maximale $Q_{max\_i}$ de la batterie 2, des pertes de capacité (totales) $\Delta Q_i$ déterminées à l'étape 110 et de la quantité de charge minimale Qmin. Plus particulièrement, la valeur cible $SOC_{cible\_i}$ de l'état de charge est déterminée à partir de la capacité de décharge maximale $Q_{max\_i}$ et de la somme des pertes de capacité $\Delta Q_i$ et de la quantité de charge minimale Qmin.

La valeur cible $SOC_{cible\_i}$ de l'état de charge est de préférence égale à la somme des pertes de capacité $\Delta Q_i$ et de la quantité de charge minimale $Q_{min}$, divisée par la capacité de décharge maximale $Q_{max\_i}$ :

$$SOC_{cible\_i} = \frac{Q_{cible\_i}}{Q_{max\_i}} = \frac{Q_{min} + \Delta Q_i}{Q_{max\_i}}$$

Dans une variante de mise en œuvre, la quantité de charge cible $Q_{cible}$ est définie supérieure à la somme des pertes de capacité $\Delta Q_i$ et de la quantité de charge minimale Qmin. En d'autres termes, il est prévu une marge de sécurité M lors du calcul de la quantité de charge cible $Q_{cible}$. Il est ainsi possible de s'assurer que la batterie 2 soit toujours en mesure de remplir son rôle. La quantité de charge cible $Q_{cible}$ est par exemple comprise entre 110 % et 150 % de la somme de la quantité de charge minimale Qmin et des pertes de capacité $\Delta Q_i$.

$$SOC_{cible\_i} = \frac{Q_{cible\_i}}{Q_{max\_i}} = \frac{M \times (Q_{min} + \Delta Q_i)}{Q_{max}}$$

avec M un coefficient de marge compris entre 110 % et 150 %.

La quantité de charge minimale $Q_{min}$ est de préférence constante d'une itération à l'autre des étapes 110 à 130 du procédé de gestion 100.

Le procédé de gestion 100 repose donc sur l'hypothèse que les pertes (réversibles et irréversibles) subies par la batterie 2 pendant l'intervalle de temps T situé entre les itérations *i* et *i+1* des étapes 110 à 130 seront inférieures ou égales aux pertes subies par la batterie 2 pendant l'intervalle de temps T situé entre les itérations *i-1* et *i* des étapes 110 à 130.

Comme les pertes de capacité ont tendance à diminuer avec le temps, la quantité de charge cible $Q_{cible\_i}$ se rapproche progressivement de la quantité de charge minimale Qmin, ce qui améliore encore la durée de vie de la batterie.

L'ajustement de l'état de charge de la batterie 2 à la valeur cible $SOC_{cible\_i}$ (troisième étape 130 du procédé de gestion 100) est réalisé soit en chargeant la batterie 2, lorsque le test de capacité se termine par une phase de décharge complète, soit en déchargeant la batterie 2, lorsque le test de capacité se termine par une phase de charge complète. La charge ou la décharge s'effectue jusqu'à atteindre la quantité de charge cible $Q_{cible\_i}$ correspondant à la valeur cible $SOC_{cible\_i}$ de l'état de charge, et préférence à courant constant. La quantité chargée ($Q_{cible\_i}$), respectivement déchargée ($Q_{max\_i}-Q_{cible\_i}$), est mesurée en intégrant le courant de charge, respectivement de décharge.

Avantageusement, le procédé de gestion 100 comporte une quatrième étape 140 de vérification de l'aptitude de la batterie 2 à stocker la quantité de charge cible $Q_{cible\_i}$. Autrement dit, on vérifie si la capacité de décharge maximale $Q_{max\_i}$, qui est égale à la capacité nominale Qo de la batterie 2 moins l'ensemble des pertes de capacité irréversibles (i.e. depuis l'origine), est supérieure ou égale à la quantité de charge cible $Q_{cible\_i}$. Si ce n'est pas le cas, la batterie 2 est à remplacer. Cette étape revient à surveiller l'état de santé $SOH_i$ de la batterie 2 qui peut être défini par l'équation suivante :

$$SOH_i = \frac{Q_{max\_i}}{Q_0}$$

Cette quatrième étape 140 de vérification est de préférence accomplie entre la deuxième étape 120 (détermination de $SOC_{cible\_i}$) et la troisième étape 130 (mise à niveau de l'état de charge) du procédé de gestion 100. Avantageusement, cette quatrième étape 140 de vérification est également effectuée périodiquement, de préférence avec la même période T que les première, deuxième et troisième étapes 110, 120, 130 du procédé de gestion 100.

Comme décrit précédemment, les pertes de capacité comportent une part liée à un courant de consommation fourni par la batterie 2. Lorsque l'on ne fait pas de gestion thermique de la batterie 2, le courant de consommation peut être considéré comme constant. Dans ce cas, la part $\Delta Q_{Rév\_conso}$ des pertes de capacité liée à ce courant de consommation $I_{conso}$ a un comportement linéaire dans le temps t et peut être définie par l'équation suivante :

$$\Delta Q_{Rév\_conso} = I_{conso}.t$$

Avantageusement, les pertes de capacité $\Delta Q_{Rév\_conso}$ dues à la consommation peuvent être compensées entre deux étapes 130 successives d'ajustement de l'état de charge. Ainsi, il est possible de réduire la valeur de la quantité de charge cible $Q_{cible}$ pour qu'elle se rapproche de la valeur de la quantité de charge minimale Qmin que la batterie 2 doit stockée. Cela permet d'optimiser davantage la gestion de l'état de charge de la batterie 2.

En pratique, les pertes de capacité $\Delta Q_{Rév\_conso}$ liées à la consommation sont généralement relativement faibles, le courant de consommation $I_{conso}$ étant de l'ordre du micro-ampère. Il peut donc être difficile de compenser ces pertes de capacité au moyen d'un courant de charge constant qui devrait être sensiblement égal au courant de consommation $I_{conso}$. Dans ce cas, la compensation de telles pertes peut s'effectuer ponctuellement et en plusieurs fois entre deux étapes 130 successives d'ajustement de l'état de charge. Le courant de charge est alors plus élevé et donc plus facile à fournir à la batterie 2.

Avantageusement, les modifications de l'état de charge de la batterie 2 qui ont lieu entre les étapes 130 d'ajustement de l'état de charge à la valeur cible $SOC_{cible\_i}$ sont intégrées au fur et à mesure de manière à ne pas altérer le calcul des pertes de capacité.

Selon une variante de mise en œuvre, la température de fonctionnement de la batterie 2, lorsqu'elle est au repos, est mesurée. Il est ainsi possible de déterminer la capacité instantanée de la batterie 2, par exemple à partir d'abaques donnant la capacité de la batterie 2 en fonction du courant de décharge et de la température. La valeur cible $SOC_{cible\_i}$ de l'état de charge peut alors être modifiée en fonction de la valeur de cette capacité instantanée pour que la fonction de la batterie 2 soit toujours assurée. A titre d'exemple, cela consiste à recharger la batterie 2 lorsque la température de fonctionnement diminue et à décharger la batterie lorsque la température de fonctionnement augmente..

## Revendications

1. Procédé de gestion (100) d'un état de charge d'une batterie (2) laissée au repos et subissant des pertes de capacité au cours du temps, le procédé de gestion étant **caractérisé en ce qu'**il comporte les étapes suivantes répétées à intervalles de temps réguliers :

   - (110) déterminer les pertes de capacité ($\Delta Q_i$) subies par la batterie (2) pendant un intervalle de temps (T) ;
   - (120) déterminer une valeur cible ($SOC_{cible\_i}$) de l'état de charge, la valeur cible ($SOC_{cible\_i}$) de l'état de charge étant égale à une quantité de charge cible ($Q_{cible\_i}$) divisée par une capacité de décharge maximale ($Q_{max\_i}$) de la batterie (2), la quantité de charge cible ($Q_{cible\_i}$) étant supérieure ou égale à la somme entre les pertes de capacité ($\Delta Q_i$) subies par la batterie (2) et une quantité de charge minimale (Qmin) nécessaire au fonctionnement pendant une durée prédéterminée d'un dispositif électrique associé à la batterie, la valeur cible ($SOC_{cible\_i}$) de l'état de charge étant strictement inférieure à 100 % ;
   - (130) ajuster l'état de charge de la batterie (2) à la valeur cible ($SOC_{cible\_i}$).

2. Procédé de gestion (100) selon la revendication 1, **caractérisé en ce que** les pertes de capacité ($\Delta Q_i$) subies par la batterie (2) sont déterminées à partir d'une précédente valeur cible ($SOC_{cible\_i-1}$) de l'état de charge et d'une quantité de charge résiduelle ($Q_{Rés\_i}$) présente dans la batterie (2).

3. Procédé de gestion (100) selon la revendication 2, **caractérisé en ce que** l'étape (110) de détermination des pertes de capacité ($\Delta Q_i$) subies par la batterie (2) comprend les sous-étapes suivantes :

   - (111) déterminer des pertes de capacité irréversibles ($\Delta Q_{Irr\_i}$) à partir d'une valeur courante ($Q_{max\_i}$) de la capacité de décharge maximale et d'une valeur précédente ($Q_{max\_i-1}$) de la capacité de décharge maximale ; et
   - (112) déterminer des pertes de capacité réversibles ($\Delta Q_{Rév\_i}$) à partir de la précédente valeur cible ($SOC_{cible\_i-1}$) de l'état de charge, de la quantité de charge résiduelle ($Q_{Rés\_i}$) présente dans la batterie (2) et des pertes de capacité irréversibles ($\Delta Q_{Irr\_i}$).

4. Procédé de gestion (100) selon l'une des revendications 2 et 3, **caractérisé en ce que** la quantité de charge résiduelle ($Q_{Rés\_i}$) présente dans la batterie (2) est mesurée lors d'une première opération d'un test de capacité et **en ce que** la capacité de décharge maximale ($Q_{max\_i}$) de la batterie (2) est mesurée lors d'une deuxième opération du test de capacité.

5. Procédé de gestion (100) selon la revendication 4, **caractérisé en ce que** le test de capacité comprend successivement une première phase de décharge complète de la batterie (2), une phase de charge complète de la batterie (2) et une deuxième phase de décharge complète de la batterie (2), la quantité de charge résiduelle ($Q_{Rés\_i}$) présente dans la batterie (2) étant mesurée lors de la première phase de décharge complète de la batterie (2) et la capacité de décharge maximale ($Q_{max\_i}$) de la batterie (2) étant mesurée lors de la deuxième phase de décharge complète de la batterie (2).

6. Procédé de gestion (100) selon la revendication 4, **caractérisé en ce que** la batterie (2) présente un rendement faradique atteignant sensiblement 100% et **en ce que** le test de capacité comprend successivement une phase de décharge complète de la batterie (2) et une phase de charge complète de la batterie (2), la quantité de charge résiduelle ($Q_{Rés\_i}$) présente dans la batterie (2) étant mesurée lors de la phase de décharge complète de la batterie (2) et la capacité de décharge maximale ($Q_{max\_i}$) de la batterie (2) étant mesurée lors de la phase de charge complète de la batterie (2).

7. Procédé de gestion (100) selon l'une quelconque des revendications 1 à 6, **caractérisé en ce qu'**il comporte en outre une étape (140) consistant à vérifier si la batterie (2) présente une capacité de décharge maximale ($Q_{max\_i}$) supérieure ou égale à la quantité de charge cible ($Q_{cible\_i}$) correspondant à la valeur cible ($SOC_{cible\_i}$) de l'état de charge.

8. Procédé de gestion (100) selon l'une quelconque des revendications 1 à 7, **caractérisé en ce que** les pertes de capacité ($\Delta Q_i$) subies par la batterie (2) comprennent des pertes réversibles dont une première partie est due à un courant de consommation délivré par la batterie (2), la première partie des pertes réversibles étant compensée entre deux étapes (130) d'ajustement de l'état de charge successives.

9. Procédé de gestion (100) selon la revendication 8, **caractérisé en ce que** la compensation de la première partie des pertes réversibles est prise en compte au cours de l'étape (110) de détermination des pertes de capacité.

10. Procédé de gestion (100) selon l'une quelconque des revendications 1 à 9, **caractérisé en ce qu'**il comporte en outre une étape de mesure d'une température de fonctionnement de la batterie (2), une capacité de décharge instantanée de la batterie (2) étant déterminée en fonction de la température de fonctionnement de la batterie (2).

11. Procédé de gestion (100) selon la revendication 10, **caractérisé en ce que** la valeur cible ($SOC_{cible\_i}$) de l'état de charge est modifiée en fonction de la capacité de décharge instantanée.

**Patentansprüche**

1. Verwaltungsverfahren (100) eines Ladezustandes einer Batterie (2), die im Ruhezustand belassen wurde und bei der im Verlauf der Zeit Kapazitätsverluste aufgetreten sind, wobei das Verwaltungsverfahren **dadurch gekennzeichnet ist, dass** es die folgenden Schritte umfasst, die in regelmäßigen zeitlichen Intervallen wiederholt werden:

   - (110) Bestimmen der Kapazitätsverluste ($\Delta Qi$), die in der Batterie (2) während eines zeitlichen Intervalls (T) aufgetreten sind;
   - (120) Bestimmen eines Zielwertes ($SOC_{cible\_i}$) des Ladezustandes, wobei der Zielwert ($SOC_{cible\_i}$) des Ladezustandes gleich einer Ziel-Lademenge ($Q_{cible\_i}$) geteilt durch eine maximale Entladekapazität ($Q_{max\_i}$) der Batterie (2) ist, wobei die Ziel-Lademenge ($SOC_{cible\_i}$) größer als oder gleich der Summe zwischen den in der Batterie (2) aufgetretenen Kapazitätsverlusten ($\Delta Q_i$) und einer Mindest-Lademenge ($Qmin$) ist, die für den Betrieb während einer vorbestimmten Dauer einer der Batterie zugeordneten elektrischen Vorrichtung notwendig ist, wobei der Zielwert ($SOC_{cible\_i}$) des Ladezustandes strikt unter 100 % beträgt;
   - (130) Einstellen des Ladezustandes der Batterie (2) auf den Zielwert ($SOC_{cible\_i}$).

2. Verwaltungsverfahren (100) gemäß Anspruch 1, **dadurch gekennzeichnet, dass** die in der Batterie (2) aufgetretenen Kapazitätsverluste ($\Delta Q_i$) ausgehend von einem vorherigen Zielwert ($SOC_{cible\_i}$) des Ladezustandes und einer restlichen Lademenge ($Q_{Rés\_i}$), die in der Batterie (2) vorhanden ist, bestimmt werden.

3. Verwaltungsverfahren (100) gemäß Anspruch 2, **dadurch gekennzeichnet, dass** der Bestimmungsschritt (110) der in der Batterie (2) erfolgten Kapazitätsverluste ($\Delta Q_i$) die folgenden Teilschritte umfasst:

   - (111) Bestimmen der irreversiblen Kapazitätsverluste ($\Delta Q_{irr\_i}$) ausgehend von einem aktuellen Wert ($Q_{maxi\_i}$)

der maximalen Entladekapazität und einem vorherigen Wert ($Q_{max\_i-1}$) der maximalen Entladekapazität; und
- (112) Bestimmen der reversiblen Kapazitätsverluste ($\Delta Q_{Rév\_1}$) ausgehend von dem vorherigen Zielwert ($SOC_{cible\_i-1}$) des Ladezustandes, der restlichen Lademenge ($Q_{Rés\_i}$), die in der Batterie (2) vorhanden ist, und der irreversiblen Kapazitätsverluste ($\Delta Q_{irr\_i}$).

4. Verwaltungsverfahren (100) gemäß einem der Ansprüche 2 und 3, **dadurch gekennzeichnet, dass** die restliche Lademenge, ($Q_{Rés\_i}$), die in der Batterie (2) vorhanden ist, bei einer ersten Durchführung eines Kapazitätstests gemessen wird und dass die maximale Entladekapazität ($Q_{max\_i}$) der Batterie (2) bei einer zweiten Durchführung des Kapazitätstests gemessen wird.

5. Verwaltungsverfahren (100) gemäß Anspruch 4, **dadurch gekennzeichnet, dass** der Kapazitätstest nacheinander eine erste Phase des kompletten Entladens der Batterie (2), eine Phase des kompletten Ladens der Batterie (2) und eine zweite Phase des kompletten Entladens der Batterie (2) umfasst, wobei die restliche Lademenge ($O_{Rés\_i}$), die in der Batterie (2) vorhanden ist, in der ersten Phase des kompletten Entladens der Batterie (2) gemessen wird und die maximale Entladekapazität ($Q_{max\_i}$) der Batterie (2) in der zweiten Phase des kompletten Entladens der Batterie (2) gemessen wird.

6. Verwaltungsverfahren (100) gemäß Anspruch 4, **dadurch gekennzeichnet, dass** die Batterie (2) eine deutlich 100 %ige Faradische Leistung aufweist und dass der Kapazitätstest nacheinander eine Phase des kompletten Entladens der Batterie (2) und eine Phase des kompletten Ladens der Batterie (2) umfasst, die restliche Lademenge ($Q_{Rés\_i}$), die in der Batterie (2) vorhanden ist, in der Phase des kompletten Entladens der Batterie (2) gemessen wird und wobei die maximale Entlladekapazität ($Q_{max\_i}$) der Batterie (2) in der Phase des kompletten Ladens der Batterie (2) gemessen wird.

7. Verwaltungsverfahren (100) gemäß irgendeinem der Ansprüche 1 bis 6, **dadurch gekennzeichnet, dass** es darüber hinaus einen Schritt (140) umfasst, der im Überprüfen besteht, ob die Batterie (2) eine maximale Entladekapazität ($Q_{max\_i}$) aufweist, die größer als oder gleich der Ziel-Lademenge ($Q_{cible\_i}$) ist, die dem Zielwert ($SOC_{cible\_i}$) des Ladezustandes entspricht.

8. Verwaltungsverfahren (100) gemäß irgendeinem der Ansprüche 1 bis 7, **dadurch gekennzeichnet, dass** die in der Batterie (2) eingetretenen Kapazitätsverluste ($\Delta Q_i$) reversible Verluste umfassen, von denen ein erster Teil auf einen von der Batterie (2) gelieferten Verbrauchsstrom zurückzuführen ist, wobei der erste Teil der reversiblen Teile zwischen zwei sukzessiven Einstellschritten (130) des Ladezustandes ausgeglichen wird.

9. Verwaltungsverfahren (100) gemäß Anspruch 8, **dadurch gekennzeichnet, dass** der Ausgleich des ersten Teils der reversiblen Verluste im Verlauf des Bestimmungsschritts (110) der Kapazitätsverluste berücksichtigt wird.

10. Verwaltungsverfahren (100) gemäß irgendeinem der Ansprüche 1 bis 9, **dadurch gekennzeichnet, dass** es darüber hinaus einen Messschritt einer Betriebstemperatur der Batterie (2) umfasst, wobei eine sofortige Entladekapazität der Batterie (2) in Abhängigkeit von der Betriebstemperatur der Batterie (2) bestimmt wird.

11. Verwaltungsverfahren (100) gemäß Anspruch 10, **dadurch gekennzeichnet, dass** der Zielwert ($SOC_{cible\_1}$) des Ladezustandes in Abhängigkeit von der sofortigen Entladekapazität abgeändert wird.

**Claims**

1. Method for managing (100) a state of charge of a battery (2) left to rest and suffering capacity losses over time, the management method being **characterised in that** it comprises the following steps repeated at regular time intervals:

   - (110) determining the capacity losses ($\Delta Q_i$) suffered by the battery (2) during a time interval (T);
   - (120) determining a target value ($SOC_{cible\_i}$) of the state of charge, the target value ($SOC_{cible\_i}$) of the state of charge being equal to a target amount of charge ($Q_{cible\_i}$) divided by a maximum discharge capacity ($Q_{max\_i}$) of the battery (2), the target amount of charge ($Q_{cible\_i}$) being greater than or equal to a sum of the capacity losses ($\Delta Q_i$) suffered by the battery (2) and a minimum amount of charge (Qmin) required to operate an electrical device associated with the battery during a predetermined duration, the target value ($SOC_{cible\_i}$) of the state of charge being strictly less than 100 %;
   - (130) adjusting the state of charge of the battery (2) to the target value ($SOC_{cible\_i}$).

**2.** Management method (100) according to claim 1, **characterised in that** the capacity losses ($\Delta Q_i$) suffered by the battery (2) are determined from a preceding target value ($SOC_{cible\_i-1}$) of the state of charge and an amount of residual charge ($O_{Rés\_i}$) present in the battery (2).

**3.** Management method (100) according to claim 2, **characterised in that** the step (110) of determining the capacity losses ($\Delta Q_i$) suffered by the battery (2) comprises the following sub-steps:

- (111) determining irreversible capacity losses ($\Delta Q_{Irr\_i}$) from a current value ($Q_{max\_i}$) of the maximum discharge capacity and a preceding value ($Q_{max\_i-1}$) of the maximum discharge capacity; and
- (112) determining reversible capacity losses ($\Delta Q_{Rév-i}$) from the preceding target value ($SOC_{cible\_i-1}$) of the state of charge, the amount of residual charge ($O_{Rés\_i}$) present in the battery (2) and the irreversible capacity losses ($\Delta Q_{irr\_i}$).

**4.** Management method (100) according to one of claims 2 and 3, **characterised in that** the amount of residual charge ($Q_{Rés\_i}$) present in the battery (2) is measured during a first operation of a capacity test and **in that** the maximum discharge capacity ($Q_{max\_i}$) of the battery (2) is measured during a second operation of the capacity test.

**5.** Management method (100) according to claim 4, **characterised in that** the capacity test successively comprises a first complete discharge phase of the battery (2), a complete charge phase of the battery (2) and a second complete discharge phase of the battery (2), the amount of residual charge ($Q_{Rés\_i}$) present in the battery (2) being measured during the first complete discharge phase of the battery (2) and the maximum discharge capacity ($Q_{max\_i}$) of the battery (2) being measured during the second complete discharge phase of the battery (2).

**6.** Management method (100) according to claim 4, **characterised in that** the battery (2) has a faradaic efficiency reaching substantially 100% and **in that** the capacity test successively comprises a complete discharge phase of the battery (2) and a complete charge phase of the battery (2), the amount of residual charge ($Q_{Rés\_i}$) present in the battery (2) being measured during the phase of complete discharge of the battery (2) and the maximum discharge capacity ($Q_{max\_i}$) of the battery (2) being measured during the complete charge phase of the battery (2).

**7.** Management method (100) according to any of claims 1 to 6, **characterised in that** it further comprises a step (140) consisting in verifying if the battery (2) has a maximum discharge capacity ($Q_{max\_i}$) greater than or equal to the target amount of charge ($Q_{cible\_i}$) corresponding to the target value ($SOC_{cible\_i}$) of the state of charge.

**8.** Management method (100) according to any of claims 1 to 7, **characterised in that** the capacity losses ($\Delta Q_i$) suffered by the battery (2) comprise reversible losses of which a first part is due to a consumption current delivered by the battery (2), the first part of the reversible losses being compensated between two successive steps (130) of adjustment of the state of charge.

**9.** Management method (100) according to claim 8, **characterised in that** the compensation of the first part of the reversible losses is taken into account during the step (110) of determining the capacity losses.

**10.** Management method (100) according to any of claims 1 to 9, **characterised in that** it further comprises a step of measuring an operating temperature of the battery (2), an instantaneous discharge capacity of the battery (2) being determined as a function of the operating temperature of the battery (2).

**11.** Management method (100) according to claim 10, **characterised in that** the target value ($SOC_{cible\_i}$) of the state of charge is modified as a function of the instantaneous discharge capacity.

100

111

112

110

120

130

140

**Fig. 1**

2    2    2

$Q_0$

$Q_{max\_i-1}$

$Q_{cible\_i-1}$

$\Delta Q_i = \Delta Q_{Rév\_i} + \Delta Q_{Irr\_i}$

$Q_{Rés\_i}$

$Q_{max\_i}$

$Q_{cible\_i}$

$Q_{min}$

**Fig. 2**

i-1

T

i

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040066171 A1
- US 2016266979 A1
- US 6664764 B1